(19) Europäisches Patentamt
European Patent Office
Office européen des brevets

(11) **EP 1 419 938 B1**

(12) **EUROPÄISCHE PATENTSCHRIFT**

(45) Veröffentlichungstag und Bekanntmachung des Hinweises auf die Patenterteilung:
**04.07.2007 Patentblatt 2007/27**

(51) Int Cl.:
***B60R 21/01*** *(2006.01)*

(21) Anmeldenummer: **04003956.2**

(22) Anmeldetag: **06.04.2000**

(54) **Verfahren zur Ansteuerung von Rückhaltemitteln**

Method for controlling restraint means

Procédé pour actionner des appareils de retenue

(84) Benannte Vertragsstaaten:
**DE FR GB IT SE**

(30) Priorität: **15.04.1999 DE 19916954**

(43) Veröffentlichungstag der Anmeldung:
**19.05.2004 Patentblatt 2004/21**

(62) Dokumentnummer(n) der früheren Anmeldung(en) nach Art. 76 EPÜ:
**00929339.0 / 1 086 003**

(73) Patentinhaber: **ROBERT BOSCH GMBH**
**70442 Stuttgart (DE)**

(72) Erfinder:
• **Mattes, Bernhard**
**74343 Sachsenheim (DE)**
• **Mehler, Gerhard**
**71254 Ditzingen (DE)**

(56) Entgegenhaltungen:
**DE-A- 3 737 554**          **DE-A- 19 724 101**

• **PHEN R L ET AL: "Advanced Air Bag Technology Assessment - Final Report" JET PROPULSION LAB PROGRESS REPORT, XX, XX, April 1998 (1998-04), XP002137509**

EP 1 419 938 B1

## Beschreibung

### Stand der Technik

Die vorliegende Erfindung betrifft ein Verfahren zur Ansteuerung von Rückhaltemitteln.

Aus dem Tagungsband des 3rd International Symposium on Sophisticated Car Occupant Safety Systems, Airbag 2000, 1996, November 26/27, Karlsruhe, Seite 16-1 bis 15-20 ist es bekannt, mittels sogenannter Precrash-Sensoren, mit denen auf der Basis von Radar oder Infrarotstrahlung oder Ultraschall der Abstand bzw. die Relativgeschwindigkeit des Fahrzeugs gegenüber einem Hindernis ermittelt werden kann, eine Vorhersage zu treffen, ob ein Crash des Fahrzeugs mit einem Hindernis bevorsteht. Außerdem ist in dieser Druckschrift ein Innenraumsensor beschrieben, der mit Infrarotstrahlung und Ultraschall die Position eines Fahrzeuginsassen auf seinem Sitz erfaßt. In Abhängigkeit von der Position des Fahrzeuginsassen wird die Auslösung, d.h. die Aufblasstärke, eines Airbags so gesteuert, daß der Insasse bei einem Fahrzeugcrash einen optimalen Schutz erfährt. Befindet sich der Fahrzeuginsasse in einer sog. Out-Of-Position Lage, in der die Auslösung eines Airbags für den Insassen eher gefährlich werden könnte, wird der Airbag deaktiviert.

Aus DE 197 24 101 A1 ist es bekannt, aus einer Precrash-Information einen Beschleunigungsverlauf während eines Crashvorgangs abzuschätzen.

Erfahrungsgemäß leitet der Fahrer eines Fahrzeugs, bevor es zu einem tatsächlichen Crash kommt, einen Bremsvorgang ein. Dieser auch als Precrash-Braking bezeichnete Bremsvorgang führt dazu, daß vor allem ein Insasse auf dem Beifahrersitz in Richtung auf den Beifahrer-Airbag vorverlagert wird. Aus der Verzögerung, die das Fahrzeug durch solch einen Bremsvorgang vor einem Crash erfährt, kann in Zusammenarbeit mit dem Innenraumsensor rechtzeitig vor dem eintretenden Crash die Positionsverlagerung des Insassen erfaßt werden, so daß dementsprechend eine Aktivierung bzw. auch Deaktivierung des Airbags eingeleitet werden kann.

### Vorteile der Erfindung

Die genannte Aufgabe wird mit den Merkmalen des Anspruchs 1 gelöst.

Gemäß der Erfindung wird also für die Erfassung eines vor einem Crash erfolgenden Bremsvorganges ein sowieso im Fahrzeug vorhandener Beschleunigungssensor verwendet, der eigentlich für die Messung von hohen bei einem tatsächlichen Crash auftretenden Beschleunigungen in Fahrzeuglängsrichtung bis zum 35-fachen der Erdbeschleunigung g bestimmt ist. Die Erfindung ermöglicht es, daß ein an sich für die Messung von sehr hohen Beschleunigungen vorgesehener Sensor auch für die Erfassung von niedrigen Verzögerungen (0,1 g bis 1 g) wie sie bei Precrash-Bremsvorgängen vorkommen, ausgenutzt wird, wobei das Meßsignal für die niedrigen Verzögerungen eine ausreichend hohe Auflösung aufweist.

### Beschreibung eines Ausführungsbeispiels

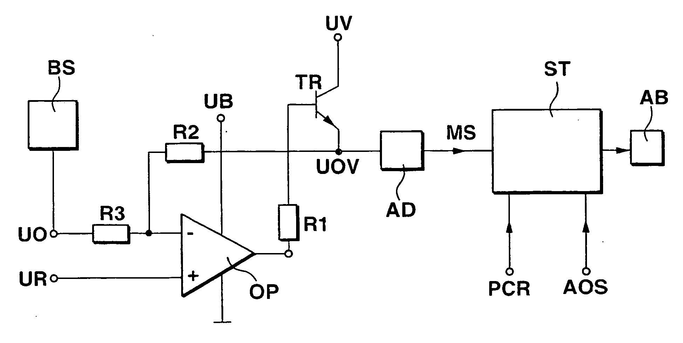

Anhand eines in der Zeichnung dargestellten Ausführungsbeispiels wird nachfolgend die Erfindung näher erläutert.

In der einzigen Figur der Zeichnung ist eine Schaltungsanordnung dargestellt, mit der Verzögerungen eines Fahrzeugs gemessen werden können, die, verursacht durch einen vor einem Crash des Fahrzeugs erfolgten Bremsvorgang, zu einer Sitzpositionsveränderung der Fahrzeuginsassen führen. Die Schaltungsanordnung mißt die Verzögerung des Fahrzeugs, und eine Steuereinheit ST, welche für die Aktivierung eines oder mehrerer Airbags AB und anderer Rückhalteeinrichtungen zuständig ist, wertet das gemessene Verzögerungssignal MS zusammen mit einer Precrash-Information PCR und der Information AOS eines Innenraumsensor aus. Kommt von einem Precrash-Sensor eine Information PCR über einen bevorstehenden Crash oder erkennt der Fahrer ein nahendes Hindernis, so ist eine danach gemessene Verzögerung MS des Fahrzeugs mit großer Wahrscheinlichkeit auf einen Bremsvorgang zurückzuführen, den der Fahrer angesichts des bevorstehenden Crashes eingeleitet hat. Diese Verzögerung führt zu einer Verlagerung der Insassen aus ihrer idealen Position heraus, so daß die Steuereinheit ST dementsprechend eine für den Schutz der Fahrzeuginsassen geeignete Ansteuerung von Rückhaltemitteln veranlaßt. Je nach der von einem Innenraumsensor erfaßten Lage AOS der Fahrzeuginsassen können Airbags mehr oder weniger stark oder in Stufen aufgeblasen werden, oder es kann eine Airbagauslösung unterbunden werden, falls die betreffende Person eine Vorverlagerung zu dicht an den Airbag heran erfahren hat.

Zur Erfassung der Fahrzeugverzögerung bei einem Bremsvorgang vor einem Crash (Precrash-Braking) wird mindestens ein Beschleunigungssensor BS verwendet, der an sich dafür vorgesehen ist, die beim Crash auftretenden Fahrzeugverzögerungen bzw. Beschleunigungen in Fahrzeuglängsrichtung zu messen. Dieser Beschleunigungssensor BS muß in der Lage sein, sehr hohe Beschleunigungen bis zu 35 g (g = Erdbeschleunigung), wie sie in Crash-Situationen auftreten, zu erfassen. Obgleich bei einem Precrash-Braking erheblich geringere Verzögerungen, nämlich von 0,1 g bis 1 g, auftreten als bei einem tatsächlichen Crash, wird der für die Erfassung hoher Beschleunigungswerte ausgelegte Beschleunigungssensor BS verwendet. Ein Beschleunigungssensor BS der für die Messung von Verzögerungen bis zu 35 g ausgelegt ist, besitzt z.B. eine Meßempfindlichkeit von 55 mV/g. Wird zur Umsetzung der analogen Ausgangsspannung des Beschleunigungssensors in ein digitales von der Steuereinheit ST zu verarbeitendes Meßsignal einem 8 Bit-Analog-Digital-Umsetzer zugeführt, so ergibt sich für das Meßsignal eine Auflösung von ca. 0,36 g/Bit. Diese Auflösung des Meßsignals ist für die Erfassung von niedrigen Verzögerungen zwischen 0,1 g und 1 g erheblich zu gering. Um trotzdem eine bessere Meßsignalauflösung mit einem 8-Bit Analog-Digital-Umsetzer AD zu erreichen, ist ein Operationsverstärker OP vorgesehen, an dessen einem Eingang die Ausgangsspannung UO des Beschleunigungssensor BS und an dessen anderem Eingang eine Referenzspannung UR angelegt wird. Durch die Verstärkung des Ausgangssignals UO, dessen Meßempfindlichkeit z.B. bei 55 m/Vg liegt, um beispielsweise den Faktor

$$10 = \left| \frac{R2}{R3} \right|$$ entsteht eine Beschleunigungs-

meßspannung UOV die mit dem anschließenden 8 Bit-Analog-Digital-Umsetzer in ein digitales Messignal MS mit genügend hoher Auflösung umgesetzt werden kann.

Die dem Analog-Digital-Umsetzer AD zugeführte Spannung UOV sollte mit seinem Hub innerhalb des von dem Analog-Digital-Umsetzer AD verarbeitbaren Spannungsbereichs liegen und auf keinen Fall die maximal mögliche Eingangsspannung des Analog-Digital-Umsetzers über- oder unterschreiten, da sonst der Analog-Digital-Umsetzer alle anliegenden Spannungswerte UOV falsch konvertieren würde. Verwendet man einen preisgünstigen bipolaren Operationsverstärker, ist nicht unbedingt gewährleistet, daß sein Ausgangsspannungshub den zulässigen Eingangspannungshub des Analog-Digital-Umsetzers nicht überschreitet. Es gibt preisgünstige Operationsverstärker (zum Beispiel der LM2904), die zum Beispiel einen Ausgangsspannungshub von Massepotiential + 1,5 V bis zur Versorgungsspannung UB - 2 V geht. Bei einer Versorgungsspannung UB des Operationsverstärkers von 8 Volt erreicht also der Ausgangsspannungshub eine obere Grenze von 6 V. Geht aber der Eingangsspannungshub des Analog-Digital-Umsetzers AD nur bis 5 V, so würde der Wandlungsbereich des Analog-Digital-Umsetzers AD von der Ausgangsspannung des Operationsverstärkers OP überschritten. Um das zu vermeiden, ist an den Ausgang des Operationsverstärkers OP ein Transistor TR in Kollektorschaltung angeschlossen. Dieser Transistor TR, dessen Vorspannung UV = 5 V beträgt, bewirkt eine Hubbegrenzung der Ausgangsspannung des Operationsverstärkers OP durch eine Basis-Kollektor-Diodenklammerung auf 5 V, so daß die am Emitter des Transistors TR liegende Eingangsspannung UOV des Analog-Digital-Umsetzers den oberen Wert 5 V des Wandlungsbereichs nicht überschreitet. Der Ausgang des Operationsverstärkers OP ist über einen Widerstand R1 an die Basis des Transistors TR gelegt, und der Emitter des Transistors TR ist über einen Gegenkopplungs-Widerstand R2 mit demjenigen Eingang des Operationsversträrkers OP verbunden, an dem die Ausgangsspannung UO des Beschleunigungssensors BS liegt.

Der 0 g-Offset des Beschleunigungssensors BS und des nachfolgenden Verstärkers OP bleibt bei der Ermittlung des Meßsignals MS unbeachtet und wird erst im Steuergerät ST bei der Bildung von Auslösekriterien berücksichtigt.

## Patentansprüche

1. Verfahren zur Ansteuerung von Rückhaltemitteln (AB), wobei in Abhängigkeit von einer Precrash-Information (PCR), einem Signal (AOS) eines Innenraumsensors und eines Verzögerungssignals (MS) die Rückhaltemittel (AB) angesteuert werden, **dadurch gekennzeichnet, dass** bei einer niedrigen Verzögerung von 0,1g bis 1g, die bei einem Precrash-Bremsvorgang, der in Abhängigkeit von der Precrash-Information (PCR) erkannt wird, vorkommt, die Rückhaltemittel (AB) angesteuert werden, wobei dabei eine durch das Signal (AOS) erfasste Lage der Fahrzeuginsassen berücksichtigt wird, wobei mindestens ein Beschleunigungssensor (BS) sowohl zur Erfassung der niedrigen Verzögerung als auch einer bei einem Crash auftretenden Verzögerung verwendet wird.

## Claims

1. Method for activating restraint means (AB), wherein the restraint means (AB) are activated as a function of precrash information (PCR), a signal (AOS) of an interior sensor and a deceleration signal (MS), **characterized in that**, at a low deceleration of 0.1 g to 1 g, which occurs during a precrash braking operation, which is recognized as a function of the precrash information (PCR), the restraint means (AB) are activated, with a position, which is detected by the signal (AOS), of the vehicle occupants being taken into consideration in the process, and with at least one acceleration sensor (BS) being used both for detecting the low deceleration and a deceleration occurring in the event of a crash.

## Revendications

1. Procédé de commande de moyens de retenue (AB) selon lequel, en fonction d'une information de précollision (PCR), d'un signal (AOS) d'un capteur d'habitacle et d'un signal de décélération (MS) on commande les moyens de retenue (AB), **caractérisé en ce que** pour une décélération faible de 0,1 g jusqu'à 1 g qui se produit au cours d'une phase de freinage de précollision, reconnue en fonction de l'information de pré-collision (PCR), on commande les moyens de retenue (AB), en tenant compte de la position des passagers du véhicule saisie par le signal (AOS), et

en utilisant au moins un capteur d'accélération (BS) à la fois pour saisir la faible décélération et aussi la décélération produite par une collision.

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19724101 A1

**In der Beschreibung aufgeführte Nicht-Patentliteratur**

- 3rd International Symposium on Sophisticated Car Occupant Safety Systems, Airbag 2000. 26. November 1996, 16-1 1520